# EUROPEAN PATENT SPECIFICATION

(11) **EP 2 883 644 B1**
(45) Date of publication and mention of the grant of the patent: **29.04.2020**
(21) Application number: 13835075.6
(22) Date of filing: 30.07.2013
(51) Int. Cl.: B23K 20/00, B23K 20/24, H01L 21/02, H01L 21/67, H01L 21/20, H01L 21/18, H01J 37/34, C23C 14/56, C23C 14/34, C23C 14/50, B81C 99/00, B32B 38/18, B32B 38/00, B81C 3/00, B32B 37/18, B23K 101/36, B32B 37/00, B29C 65/02, B23K 20/16, B23K 20/02

(54) **NORMAL TEMPERATURE BONDING DEVICE AND NORMAL TEMPERATURE BONDING METHOD**
VORRICHTUNG ZUR BINDUNG BEI NORMALER TEMPERATUR UND VERFAHREN ZUR BINDUNG BEI NORMALER TEMPERATUR
DISPOSITIF DE COLLAGE À TEMPÉRATURE ORDINAIRE ET PROCÉDÉ DE COLLAGE À TEMPÉRATURE ORDINAIRE

(30) Priority: 07.09.2012 JP 2012196705
(43) Date of publication of application: 17.06.2015
(73) Proprietor: Mitsubishi Heavy Industries Machine Tool Co., Ltd., Shiga, 520-3080 (JP)
(72) Inventor: TSUNO Takeshi, Tokyo 108-8215 (JP); GOTO Takayuki, Tokyo 108-8215 (JP); KINOUCHI Masato, Tokyo 108-8215 (JP); UTSUMI Jun, Tokyo 108-8215 (JP); IDE Kensuke, Tokyo 108-8215 (JP); SUZUKI Takenori, Tokyo 108-8215 (JP)
(74) Representative: Henkel & Partner mbB
(86) International application number: PCT/JP2013/070571
(87) International publication number: WO 2014/038314

(56) References cited:
- EP-A1- 2 248 625
- WO-A1-2008/029885
- WO-A1-2012/043054
- WO-A1-2012/105474
- WO-A2-2006/132916
- JP-A- S5 986 147
- JP-A- H02 273 537
- JP-A- H10 121 232
- JP-A- H11 172 441
- JP-A- 2007 281 203
- JP-A- 2009 164 197
- US-A- 6 143 149
- US-A- 6 155 436
- US-A1- 2004 089 542
- US-A1- 2006 289 304

## Description

### Technical Field

The present invention relates to a room-temperature bonding apparatus and a room-temperature bonding method, especially, to a room-temperature bonding apparatus and a room-temperature bonding method which bond a plurality of substrates by contacting the activated surfaces of the substrates each other.

### Background Art

A MEMS (Micro Electro Mechanical Systems) device is known in which minute electrical parts and mechanical parts are integrated. As the MEMS device, a micro machine, a pressure sensor, a micro motor and so on are exemplified. A semiconductor device is known in which semiconductor wafers for LSI (Large Scale Integration) are laminated. In such a semiconductor device, it is possible to reduce the increase of leakage current, the delay of a signal on a wiring line, and so on.

The room-temperature bonding is a technique that for example, wafer surfaces activated in a vacuum ambience are opposed to each other so as to bond the wafers. The room-temperature bonding is suitable to form the MEMS device and the semiconductor device. Therefore, in recent years, the MEMS device and the semiconductor device are manufactured by using a room-temperature bonding apparatus and the devices using the room-temperature bonding have become popular. In association with the above, the bonding between substrates of different materials is required, such as the bonding between substrates of materials which are never bonded by now and the bonding between substrates of materials which are difficult to bond, in the room-temperature bonding. However, because the etching rate and the thickness of an oxide film or an absorption film are different for every material among different kind of materials, the bonding between substrates of the different kind of materials is difficult generally.

In the room-temperature bonding, as a technique of bonding substrates of materials which are difficult to bond, a technique is known that the bonding strength is improved by disposing a layer of another material between the bonding surfaces of the substrates. For example, such a bonding method is disclosed in JP H06-99317 A. In this bonding method, a particle beam is irradiated to the bonding surfaces of the two substrates in a super pure ambient. Then, one of the two bonding surfaces is sputtered with the particle beam to form a fine particle film on the other bonding surface. After that, the bonding surfaces are faced each other and the bonding surfaces are bonded by slightly pressurizing.

Also, a substrate bonding method is disclosed in JP 2004-337927 A. In this substrate bonding method, a plurality of substrates are bonded. This substrate bonding method has two steps of a first step and a second step. In the first step, an inactive gas ion beam or an inactive gas neuter atom beam, and a metal ion beam or a metal neuter atom beam are irradiated at the same time to a bonding surface of each of the substrates in vacuum. Through a balance of a sputtering operation of the substrate surface with the inactive gas ion beam or the inactive gas neuter atom beam and a deposition operation of metal atoms with the metal ion beam or the metal neuter atom beam, a thin metal film having the film thickness of 1 nm to 10 nm is formed on the bonding surface of each substrate. In the second step, the bonding surfaces are opposed to each other so as to bond the substrates through the thin metal film as a medium.

Also, a room-temperature bonding method is disclosed in US 4,172,806 B. This room-temperature bonding method bonds a plurality of substrates at the room-temperature through an intermediate layer. This room-temperature bonding method includes a first step and a second step. In the first step, the intermediate layers are formed on the bonding surfaces of the substrates by physically sputtering a plurality of targets. In the second step, the bonding surface of each of the substrates is activated by the physical sputtering. That is, in this room-temperature bonding method, an energy line (e.g. an ion beam, an atomic beam) is irradiated to a target formed of a plurality of kinds of materials. Thus, the intermediate layer having a uniform thickness is formed on the bonding surface of the substrate by sputtering the target. In this way, the bonding is achieved at the room-temperature to have enough bonding strength without heating in the bonding. In this case, the pressurizing and the heating are unnecessary in the bonding.

On the other hand, in a manufacturing line of the MEMS devices or the semiconductor devices, it is extremely important to prevent metal impurity from being mixed into the device (metal pollution), from the viewpoint of the manufacturing yield, the reliability, and so on. Therefore, a possibility that the metal impurity adheres to a manufacturing line and another device through the scattering of metal existing in the MEMS device or the semiconductor device in the manufacturing process to pollute them must be made as close to "0" as possible. In the above-mentioned room-temperature bonding method, some beam is irradiated to the substrate and the target, but there is a possibility that a part of the beam is irradiated to other members in the vacuum chamber other than the substrate and the target. At that time, the other members are sputtered so that there is a possibility that particles of the other members adhere to the bonding surface and side surface of the substrate and an intermediate layer on the substrate. In this case, because the members are mainly formed of metal material, metal emitted from an un-intentional one of the members might adhere to the substrate as metal impurity. There is a possibility that the metal impurity adheres to the manufacturing line and another device by applying such a polluted bonding substrate to the following manufacturing line. As a result, there is a possibility that the function of the other device is obstructed due to such a metal impurity.

Also, in the MEMS device and the semiconductor device, there is a request that a total amount of an intermediate layer, especially metal intermediate layer should be reduced as far as possible, or the intermediate layer should be omitted partially, from the similar viewpoint. In a method of US 4,172,806 B, an energy line which carries out a target etching to form the intermediate layer and an energy line which etches the bonding surface of the substrate are the same. Therefore, when the energy of the energy line is reduced to reduce a gross amount of the intermediate layer, the etching of the bonding surface becomes weak at the same time. That is, it was difficult to control the forming of the intermediate layer and the etching of the bonding surface independently. There is a possibility that the enough bonding strength cannot be obtained when the etching of the bonding surface becomes weak so that the activation cannot be sufficiently carried out.

WO 2012/043054A1 or family member EP 2624280A1 discloses a room-temperature bonding apparatus and method comprising a vacuum chamber, an electrostatic chuck formed from a dielectric layer that is formed of alumina-based ceramic, for holding a waver to be processed, and a pressure welding mechanism. The device also includes an ion gun provided with a metal target for irradiating argon ions to the waver held by the electrostatic chuck. A metal target is formed of a plurality of metals and is arranged in a position where the argon ions are irradiated to emit the atoms of the plurality of metals to the inner space of the vacuum chamber. In another embodiment the document discloses a substrate holding element formed of quartz provided in a vacuum chamber of a heat chamber of a room-temperature bonding apparatus.

EP 2248625 A1 discloses a room-temperature bonding method and room-temperature bonding apparatus in which the target holding mechanism has a plurality of areas in which a plurality of targets (or pseudo targets) of a first material can be arranged but the document does not anticipate to actually provide a pseudo target of the first material in at least one of the plurality of areas of such target holding mechanism. JP2009164197 discloses a bonding chamber, where the inner walls are covered with quartz, to avoid contamination of the substrates.

### Summary of the Invention

An object of the present invention is to provide a room-temperature bonding apparatus and a room-temperature bonding method, in which the adhesion of impurities to substrates can be restrained, when the substrates are bonded at a room-temperature.

Another aspect of the present invention is to provide a room-temperature bonding apparatus and a room-temperature bonding method, in which the formation of an intermediate layer on a bonding surface of each of substrates and the etching of the bonding surface can be controlled independently, when the substrates are bonded at a room-temperature after the intermediate layers are formed.

Further another aspect of the present invention is to provide a room-temperature bonding apparatus and a room-temperature bonding method, in which a manufacturing yield of devices using the bonded substrates and a reliability of the devices can be improved, when the substrates are bonded at a room-temperature.

Further another aspect of the present invention is to provide a room-temperature bonding apparatus and a room-temperature bonding method, in which a possibility that a manufacturing line for the devices using the bonded substrates is polluted with an impurity can be reduced, when the substrates are bonded at a room-temperature.

The room-temperature bonding apparatus of the present invention includes the features of claim 1. In such a room-temperature bonding apparatus, a phenomenon can be restrained that at least one of a plurality of members is sputtered so that the sputtering particles adhere to the substrates. Or, even if the sputtering particles adhere to the substrates, it is possible to restrict the sputtering particles to a material which does not obstruct the function of the device. Thus, it can be prevented that the material (e.g. metal impurity) which are contained in the sputtering particles and which obstructs the function of the device remains in the bonding substrates. As a result, it is possible to improve the manufacturing yield of the devices using the bonding substrates and the reliability of the devices, and to reduce a possibility that a manufacturing line of the device is polluted with the impurity. Here, the material which is difficult to be sputtered is a material that an argon sputtering yield is relative low (a material lower than a predetermined reference value of the argon sputtering yield) when sputtering with argon (Ar). The material which does not obstruct the function of the device is a material which never makes an electric, magnetic and optical functions decline and obstructs the function in case of existing in the bonding surfaces. The covering member is a member disposed in front of the irradiated surface along the irradiated surface, and a thin plate member and a thin film member are exemplified. The covering member may be in contact with the irradiated surface and be apart from the irradiated surface.

In the room-temperature bonding apparatus of the present invention, when the first substrate is a silicon substrate, the first material contains silicon oxide as the main component. In such a room-temperature bonding apparatus, the influence of the sputtering particles on the device can be retrained. Here, the silicon oxide as the first material contains quartz.

In the room-temperature bonding apparatus of the present invention, when the first substrate is a sapphire substrate, the first material contains aluminum oxide as the main component. In such a room-temperature bonding apparatus, the influence of the sputtering particles on the device can be restrained in case of using a sapphire substrate for the bonding substrate. Here, aluminum oxide as the first material contains sapphire.

In the room-temperature bonding apparatus of the present invention, the first material in one alternative contains an insulator. In such a room-temperature bonding apparatus, even if at least one of the members other than the target is sputtered and the sputtering particles adhere to the intermediate layer and the substrate, the influence of the sputtering particles on the device can be suppressed.

In the room-temperature bonding apparatus of the present invention, the covering member covers the inner surface of the vacuum chamber, is disposed to be detachable or exchangeable from said vacuum chamber, and contains a layer covering a surface for the activation beam to be irradiated. In such a room-temperature bonding apparatus, because an area where a member is installed is unnecessary, comparing the covering layer and some member to be used, the area in the apparatus can be effectively used.

The room-temperature bonding equipment of the present invention further includes the target holding mechanism disposed in the vacuum chamber to hold a target. The target holding mechanism includes a plurality of areas where a plurality of targets are arranged. A pseudo target of the first material is arranged in an area where any target is not arranged of the plurality of areas. In such a room-temperature bonding apparatus, it is possible to change the film thickness and composition of the intermediate layer without without changing a condition of the activation beam from the beam source by adjusting the area and composition of the plurality of targets used to form the intermediate layer. Thus, the intermediate layer having desired characteristics can be formed independently from the etching condition of the substrate with the activation beam. In addition, the phenomenon can be restrained that an area where any target is not arranged in the target holding mechanism is sputtered and the sputtering particles adhere to the intermediate layer and the substrate.

In the room-temperature bonding apparatus of the present invention, it is desirable that the target holding mechanism is formed of the first material, or the surface to be irradiated with the activation beam is covered with the covering member formed of the first material. It is desirable that the beam source emits the activation beam which is irradiated to the bonding surfaces of the first and second substrates and the target. It is desirable that the pressure bonding mechanism bonds the bonding surfaces of the first and second substrates on which the material of the target is adhered. In such a room-temperature bonding apparatus, the phenomenon can be restrained that the target holding mechanism is sputtered and the sputtering particles adhere to the substrate. Or, even if the sputtering particles adhere to the substrate, it is possible to limit the material of the sputtering particles which does not obstruct the function of the device.

A room-temperature bonding method of the invention includes the features of claim 4 comprising providing a room-temperature bonding apparatus of the invention, holding a first substrate by said first holding mechanism and a second substrate by said second holding mechanism, irradiating the activation beam from said beam source to bonding surfaces of the first and second substrates, and bonding the bonding surfaces of the first and second substrates to which the activation beam is irradiated, by said pressure bonding mechanism. In such a room-temperature bonding method, in the irradiating the activation beam from the beam source, the phenomenon can be restrained that at least one of the plurality of members is sputtered and the sputtering particles adhere to the substrates. Or, even if the sputtering particles adhere to the substrates, the material of the sputtering particles can be limited to a material which does not obstruct the function of the device. Thus, it is possible to strain that the material which is contained in the sputtering particles and which obstructs the function of the device remains in the bonding substrates. As a result, a manufacturing yield of the device using the bonding substrates and the reliability of the device can be improved, and a possibility that the manufacturing line of the device is polluted with the impurity can be reduced.

In the room-temperature bonding method of the present invention, it is desirable that the bonding of the bonding surfaces by the pressure bonding mechanism includes bonding the bonding surfaces of the first and second substrates to which the material of the target adheres by the pressure bonding mechanism. In such a room-temperature bonding method, the phenomenon can be restrained that the target holding mechanism is sputtered so that the sputtering particles adhere to the substrate. Or, even if the sputtering particles adhere to the substrates, the material of the sputtering particles can be limited to a material which does not obstruct the function of the device.

According to the present invention, when the substrates are bonded at the room-temperature, it is possible to restrain adhesion of the impurity to the substrates. When the intermediate layer is formed between the substrates, the forming of the intermediate layer and the etching of the bonding surfaces of the substrates can be controlled independently. It is possible to improve the manufacturing yield of the devices using the substrates bonded through the room-temperature bonding and the reliability of the devices. It is possible to reduce a possibility that the manufacturing line of the devices using the substrates bonded by the room-temperature bonding is polluted with the impurity.

### Brief Description of the Drawings

FIG. 1 is a sectional view showing the configuration of a room-temperature bonding apparatus according to a first example.
FIG. 2 is a perspective view schematically showing the configuration of the room-temperature bonding apparatus according to the first example.
FIG. 3 is a plan view showing an example of the configuration of a target holding substrate in the first example.
FIG. 4 is a side view showing an example of a device manufactured by a room-temperature bonding method according to the first example.
FIG. 5 is a sectional view showing the configuration of the room-temperature bonding apparatus according to an embodiment.
FIG. 6A is a sectional view showing the configuration of the room-temperature bonding apparatus according to a second example.
FIG. 6B is a sectional view showing an example in a covering layer.
FIG. 7A is a perspective view schematically showing the configuration of the room-temperature bonding apparatus according to the second example.
FIG. 7B is a sectional view schematically showing an example of the target holding substrate.
FIG. 7C is a sectional view schematically showing an example of the target holding substrate.
FIG. 8A is a sectional view showing the configuration of the room-temperature bonding apparatus according to a third example.
FIG. 8B is a sectional view showing an example in a covering layer.
FIG. 9 is a graph showing the effect of the embodiment.

### Description of Embodiments

Hereinafter, a room-temperature bonding apparatus and a room-temperature bonding method according to embodiments of the present invention will be described with reference to the attached drawings.

### [First Example]

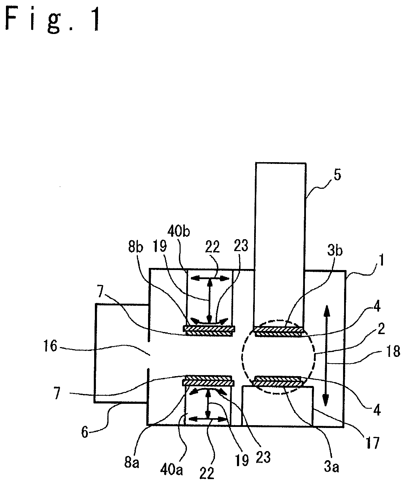

First, the configuration of the room-temperature bonding apparatus according to a first example serving to explain certain features of the present invention will be described. FIG. 1 is a sectional view showing the configuration of the room-temperature bonding apparatus according to the present example. The room-temperature bonding apparatus includes a vacuum chamber 1, an exhaust unit 2 and an atomic beam source 6. The vacuum chamber 1 is a chamber whose internal space can be exhausted to a vacuum state. For example, the vacuum chamber 1 is made of stainless steel and has a rectangular parallelepiped shape or a circular cylinder shape. The exhaust unit 2 is disposed to one of the sides of the vacuum chamber 1. The exhaust unit 2 exhausts gas inside the vacuum chamber 1. In FIG. 1, an exhaust port of the exhaust unit 2 is drawn in a circle (broken line). As the exhaust unit, a combination of a turbo molecular pump and a rotary pump is shown. The atomic beam source 6 is disposed for another of the sides of the vacuum chamber 1. The atomic beam source 6 generates a fast atom beam (ex. FAB; a gas species: argon Ar, neon Ne, krypton Kr, xenon gas Xe, and so on), and irradiates the fast atom beam from an opening section (irradiation port) 16 disposed in the other side into the vacuum chamber 1. Note that there may be a plurality of atom beam sources 6. The arrangement positions of the atom beam sources 6 are determined according to the purpose of the irradiation of atomic beams.

Moreover, the vacuum chamber 1 includes a positioning stage carriage 3a and an alignment mechanism 17. For example, the positioning stage carriage 3a and the alignment mechanism 17 are made of stainless steel. The positioning stage carriage 3a is formed to be like a board. The positioning stage carriage 3a is arranged inside the vacuum chamber 1 and is supported to be movable in a direction parallel to a horizontal direction and to be rotatable around a rotation axis parallel to a vertical direction. When a substrate 4 is conveyed in a condition that the substrate 4 is located on a cartridge (not shown), the positioning stage carriage 3a holds the substrate 4 by holding the cartridge on which the substrate (or wafer) 4 is put. The alignment mechanism 17 drives the positioning stage carriage 3a so that the positioning stage carriage 3a moves in the direction parallel to the horizontal direction or the positioning stage carriage 3a is rotated around the rotation axis parallel to the vertical direction.

Moreover, the vacuum chamber 1 includes a pressure bonding mechanism 5 and an electrostatic chuck 3b. For example, the pressure bonding mechanism 5 is made of stainless steel. The electrostatic chuck 3b is arranged inside the vacuum chamber 1 and is arranged straightly above the positioning stage carriage 3a in the vertical direction. The electrostatic chuck 3b is supported by the vacuum chamber 1 to be movable in the direction parallel to the vertical direction. The electrostatic chuck 3b has a dielectric layer. The electrostatic chuck 3b has a lower end with a flat surface which is substantially perpendicular to the vertical direction. Moreover, the electrostatic chuck 3b has an internal electrode disposed inside a dielectric layer. In the electrostatic chuck 3b, a predetermined voltage is applied to the internal electrode. Thus, the electrostatic chuck 3b holds the substrate (or wafer) 4 which is arranged in the neighborhood of the flat surface of the dielectric layer with electrostatic force.

The pressure bonding mechanism 5 drives the electrostatic chuck 3b to move along a direction parallel to the vertical direction (line 18 in FIG. 1) with respect to the vacuum chamber 1. For example, the pressure bonding mechanism 5 moves the electrostatic chuck 3b to one position of a plurality of predetermined positions. Moreover, the pressure bonding mechanism 5 measures a position where the electrostatic chuck 3b is arranged, to output the measured result. Moreover, the pressure bonding mechanism 5 measures a load which is applied to the substrate 4 held by the electrostatic chuck 3b to output the measured result. Moreover, when the lower surface of the pressure bonding mechanism 5 contacts the upper surface of the alignment mechanism 17, the pressure bonding mechanism 5 can apply a load onto the alignment mechanism 17. Therefore, when an upper substrate 4 held by the electrostatic chuck 3b which is disposed on the lower surface of the pressure bonding mechanism 5 contacts a lower substrate 4 held by the positioning stage carriage 3a on the upper surface of the alignment mechanism 17, the pressure bonding mechanism 5 can apply the load to the lower substrate 4 through the upper substrate 4.

Moreover, the vacuum chamber 1 includes target holding substrates 8a and 8b, target moving mechanisms 40a and 40b. The target holding substrate 8a is disposed on the side of the atomic beam source 6 in the horizontal direction from the positioning stage carriage 3a. The target moving mechanism 40a holds the target holding substrate 8a to be movable in the vertical direction 19 and the horizontal direction 22, and moreover to be changeable in a orientation to the opening section 16 of the atomic beam source 6, and the orientation 23 to the substrate 4. The target holding substrate 8b is disposed on the side of the atomic beam source 6 in the horizontal direction of the electrostatic chuck 3b. In the same way, the target moving mechanism 40b holds the target holding substrate 8b to be movable in the vertical direction 19 and the horizontal direction 22 and moreover to be changeable in the orientation to the opening section 16 of the atomic beam source 6, and the orientation 23 to the substrate 4. The target holding substrates 8a and 8b can be moved to the positions where the fast atom beam 9 from the atomic beam source 6 does not cross the irradiated surface of targets 7 at least, by the target moving mechanisms 40a and 40b.

The targets 7 are located on the upper surface of the target holding substrate 8a and the lower surface of the target holding substrate 8b. The target 7 has a plate-like bulk shape. As the materials of the targets 7, materials are used which are appropriate for an intermediate layer which assists the bonding of the substrates 4 when the upper substrate 4 and the lower substrate 4 are bonded. The target material is appropriately selected, depending on the situation of the bonding surfaces of the substrates. A metal material (containing alloy material), a semiconductor material, an insulator material are exemplified as the materials. A complicated mechanism is required if the direction of the fast atom beam irradiated from the atomic beam source 6 is changed. For this reason, the direction of the fast atom beam is fixed. The target moving mechanisms 40a and 40b change the positions and orientations of the target holding substrates 8a and 8b so as to control the thickness of the intermediate layer formed on the substrate surface in the direction orthogonal to the substrate surface, the uniformity of the thickness, and the uniformity of the concentrations of materials of the intermediate layer.

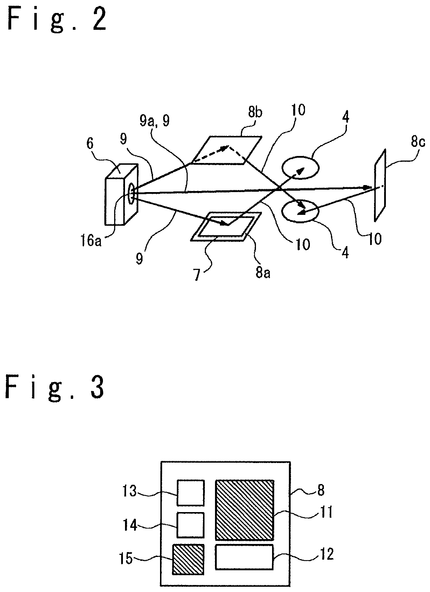

FIG. 2 is a perspective view schematically showing the configuration of the room-temperature bonding apparatus according to the present example. As shown in FIG. 2, the room-temperature bonding apparatus may further include a target holding substrate 8c (containing a target 7) in a front position of the atomic beam source 6. The fast atom beam 9 irradiated from the atom beam source 6 is incident on the targets 7 located on the target holding substrates 8a, 8b and 8c. The target 7 is sputtered so that the target material is emitted from the target 7 as sputter particles 10 for the substrate 4 on the electrostatic chuck 3b and the substrate 4 on the positioning stage carriage 3a.

Moreover, the fast atom beam 9 which is not incident on the target 7 is incident directly on the substrate 4 to sputter and etch the surface of the substrate 4. Therefore, at this time, the deposition of the sputtering particles 10 from the target 7 and the activation of the surface by the sputtering and etching are performed at a same time on the bonding surface of the substrate 4. That is, the two reactions, i.e. the cleaning of the surface and the forming of an intermediate layer, progress at the same time. Thus, the intermediate layer which is very clean and has a high activity can be formed.

In this case, the target holding substrates 8a and 8b (containing the targets 7) are not located on the central axis line 9a of the atomic beam source 6. However, the central axis line 9a of the atomic beam source 6 is an axis line extending from the center 16a of the opening section 16 of the atomic beam source 6 to a perpendicular direction (horizontal direction) to the surface of opening section 16. On the other hand, the target holding substrate 8c (containing the target 7) may be in a plane orthogonal to the central axis line 9a.

Note that the carrying-in and carrying-out of the substrate 4 are not shown in FIG. 1 and FIG. 2. For example, a load lock chamber is disposed to communicate with the vacuum chamber through a gate valve. By using a robot arm disposed in the load lock chamber, the mounting and removal of the substrate 4 to and from the positioning stage carriage 3a and the electrostatic chuck 3b can be carried out.

FIG. 3 is a plan view showing an example of the configuration of the target holding substrate 8 (8a, 8b, 8c) according to the present example. On the target holding substrate 8, a plurality of areas are disposed where a plurality of targets can be arranged, instead of an area where a singular target is arranged. In an example shown in FIG. 3, five areas are disposed. Instead of the singular target 7, a plurality of targets 11 to 15 are arranged in the plurality of areas. The plurality of targets 11 to 15 may be formed of a same material (e.g. element, compound, and alloy) and may be formed of materials different from each other. All of the plurality of areas do not have to be identical. Using such a target holding substrate 8 and the plurality of targets 11 to 15, the composition of the intermediate layer can be controlled to a desired composition based on the areas of the targets and the compositions of the targets.

Especially, a case where the condition of the fast atom beam irradiated from the atomic beam source 6 should be constant, i.e. a case where the condition of the sputtering and etching is constant will be discussed below. Even in such a case, the following method can be adopted in order to form the intermediate layer having a desired characteristic. For example, regarding the film thickness of the intermediate layer, it is possible to adjust the area of the target. That is, the maximum film thickness is obtained by arranging the target in all of the plurality of areas and the minimum film thickness is obtained by arranging the target only in the minimum area of the plurality of areas. Also, regarding the composition of the intermediate layer, it is possible to adjust the whole composition of the intermediate layer based on the compositions of the materials which are contained in the targets arranged in the plurality of areas.

In this way, by adjusting the area and composition of the target to form the intermediate layer, the film thickness and composition of the intermediate layer can be changed without changing the condition of the fast atom beam from the atomic beam source 6. Thus, the intermediate layer which has the desired characteristics can be formed independently from the etching condition of the substrate by the fast atom beam.

Here, there would be a case where it is not required to arrange targets in all of the plurality of areas from the necessary characteristics (composition, film thickness, and so on) for the intermediate layer. For example, in FIG. 3, a case where the targets 12, 13, and 14 are necessary but the targets 11 and 15 are not necessary will be considered. In this case, the targets 11 and 15 can be removed but the exposed area of the target holding substrate 8 becomes large. The fast atom beam is irradiated to the exposed area of the target holding substrate 8, even if the targets 11 and 15 are removed. Because the exposed area becomes large, there would be a possibility that the target holding substrate 8 is sputtered. In such a case, there is a possibility that the sputtered particles are deposited on the upper substrate 4 and the lower substrate 4 as a metal impurity.

Therefore, in the present example, a pseudo target formed of a material difficult to be sputtered (etched) with the fast atom beam is arranged on the target holding substrate 8 as the targets 11 and 15. However, the material difficult to be sputtered (etched) with the fast atom beam is a material whose argon Ar sputtering yield is relatively low, compared with the targets 12 to 14, when the gas species of the fast atom beam is argon Ar. For example, when the targets 12 to 14 are metal materials, insulating materials and ceramic materials are exemplified. As the insulating material, silicon oxide (containing quartz) and aluminum oxide (containing sapphire) are exemplified. When the targets 12 to 14 are formed of metal materials, the materials of the targets 11 and 15 may be metal materials which are more difficult to be etched than the metal materials of the targets 12 to 14. Yttrium and tungsten are exemplified as such metal materials.

Or, in the present example, a pseudo target may be arranged on the target holding substrate 8 as the targets 11 and 15, wherein the pseudo target is formed of a material which does not obstruct the function of a device obtained by bonding the upper and lower substrates 4, even if the material is in the bonding surfaces of the upper and lower substrates 4. However, the material which does not obstruct the function of the device means a material that the influence on the electric, magnetic, and optical functions of the device is low. As such a material, an insulating material and a material which contains the same element as an element of a main component of the substrate 4 are exemplified. However, the main component is a component with the highest rate of the material. As the insulating material, silicon oxide (containing quartz) and aluminum oxide (containing sapphire) are exemplified. Also, as the material which contains the element of the main component of the substrate 4, silicon and silicon oxide are exemplified when the substrate 4 is formed of silicon, and aluminum and aluminum oxide are exemplified when the substrate 4 is formed of sapphire.

In the target holding substrate 8, it is possible to reduce an impurity from the bonding surface and reduce the influence of the impurity, by using a material difficult to be sputtered (etched) with the fast atom beam or a material not to obstruct the function of the device as the pseudo-target for an area where the target needs not to be arranged. Note that the target holding substrate 8 (8a, 8b, 8c) itself may be formed of material which is difficult to be sputtered (etched) with the fast atom beam or which does not obstruct the function of the device. In this case, it is possible to reduce the impurity in the bonding surface, and reduce the influence of the impurity.

Next, the room-temperature bonding method (the operation of the room-temperature bonding apparatus) according to the present example will be described.

The room-temperature bonding apparatus configured as mentioned above is prepared. However, the targets 11 to 15 are used (FIG. 3). Note that in this example, it is supposed that the target holding substrate 8c is not used. Also, it is supposed that the target holding substrates 8a and 8b and the targets 11 to 15 are installed previously.

Two sheets of substrates 4 used for the bonding are previously carried into the load lock chamber (not shown) which has been exhausted to a vacuum state. The two sheets of substrates 4 used for the bonding are conveyed into the vacuum chamber 1 that has been exhausted to the vacuum, through the gate valve (not shown) by a conveyer means (not shown) in the state that the substrates are located on the cartridges (not shown). One sheet of the substrate 4 is located under the electrostatic chuck 3b in the state that the substrate 4 is located on the cartridge. The electrostatic chuck 3b holds the substrate 4 with electrostatic force. At this time, the lower surface of the pressure bonding mechanism 5 is in a position above the upper surface of the positioning stage carriage 3a in a direction opposite to the direction of gravitational force. The cartridge made empty is carried out to the load lock chamber by a conveyer means. Also, the other sheet of substrate 4 is located on the upper surface of the positioning stage carriage 3a in the state that the substrate 4 is located on the cartridge. The positioning stage carriage 3a holds the substrate 4 by holding the cartridge on which the substrate 4 is located.

After locating the two sheets of substrates 4, the gate valve is closed and the vacuum chamber 1 is vacuumed to a predetermined degree of vacuum by using the exhaust unit 2. After that, the atomic beam source 6 is started, to irradiate the fast atom beam 9. The fast atom beam 9 is irradiated on the targets 11 to 15 to sputter the elements of which the targets 12 to 14 are formed. The sputtering particles 10 from the targets 12 to 14 are deposited on the substrates 4 to form the intermediate layers. At this time, for example, when the targets 11 and 15 are formed of the material which is difficult to be sputtered with the fast atom beam, the elements of which the targets 11 and 15 are formed are hardly sputtered. Because the sputtering particles from the targets 11 and 15 are very few, the sputtering particles hardly reach the substrate 4 so that the intermediate layers are almost not polluted.

On the other hand, in parallel to these processes, the fast atom beam 9 which is not incident on the targets 11 to 15 is irradiated to the bonding surfaces of the substrates 4 to sputter and etch the surfaces. At this time, the deposition of sputtering particles 10 from the target 12 to 14 and the activation of the surfaces by the sputter and etching are performed at the same time at the bonding surfaces. The deposition and the activation depends on the materials of the targets 12 to 14 and the arrangement thereof, the intensity of the fast atom beam 9 from the atomic beam source 6, and an energy density distribution in a perpendicular direction to the central axis line 9a. Therefore, these conditions are adjusted such that the deposition exceeds the sputtering and etching so that the intermediate layer of a desired film thickness is formed. Note that the sputtering and etching means that an energy line is irradiated to a target to occur the sputtering so that the irradiated portion of the target is physically shaved.

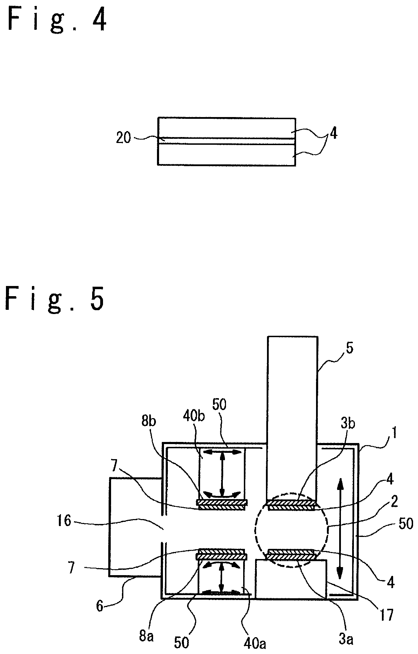

After the deposition and the activation end, the atomic beam source 6 is stopped to stop the irradiation of the fast atom beam. After that, the pressure bonding mechanism 5 is driven to bring the lower surface of the pressure bonding mechanism 5 close to the surface of the alignment mechanism 17. When the bonding surfaces of the upper substrate 4 and lower substrate 4 contact each other, the pressure bonding mechanism 5 is controlled to apply a predetermined load and sustains the application of load for a predetermined time just as it is. The fixation of the upper substrate 4 and the electrostatic chuck 3b is cancelled after the predetermined time elapses, and the pressure bonding mechanism 5 is driven to separate the lower surface of the pressure bonding mechanism 5 from the upper surface of the alignment mechanism 17. Thus, the substrates 4 which are bonded through the intermediate layers are left on the positioning stage carriage 3a. FIG. 4 is a side view showing an example of the device manufactured by the room-temperature bonding method according to the present example. The two sheets of substrates 4 are bonded through the intermediate layers 20. For example, at this time, because the targets 11 and 15 not used for forming the intermediate layers are formed of material which is difficult to be sputtered with the fast atom beam, there is no case that the material is mixed into the intermediate layers.

After that, the bonded substrates 4 are carried to the load lock chamber by the conveyer means together with the cartridge. Then, the bonded substrate 4 is taken out of the room-temperature bonding apparatus. New substrates are located in the load lock chamber and the room-temperature bonding is carried out by the same method, according to necessity.

By carrying out the room-temperature bonding as mentioned above, a plurality of kinds of materials (e.g. targets 12 to 14) can be mixed into the bonding surfaces of the substrates 4 as the material of the intermediate layers 20 so that the intermediate layers 20 can be uniformly formed. As a result, the heating and the excessive application of load which were necessary in the conventional room-temperature bonding method are made unnecessary and the substrates which are difficult to bond can be bonded. Note that the same effect can be achieved in the same method even in case that the target holding substrate 8c is used.

In the present example, for example, because the area (e.g. of targets 11 and 15) not used for forming the intermediate layer 20 is formed of the material difficult to be sputtered with the fast atom beam, it is possible to restrain that the material of the area is mixed into the intermediate layer. Or, in the above example, for example, because the area (e.g. targets 11 and 15) not used for forming the intermediate layer 20 is formed of a material which does not obstruct the function of the device, it is possible to prevent the influence on the function of the device even if the material of the area is mixed into the intermediate layer.

Moreover, in the present example, by adjusting the arrangement of the materials of the targets (12 to 14) used to form the intermediate layer and the materials of the pseudo-targets (11 and 15) not used to form the intermediate layer, and the areas of these materials, the film thickness and composition of the intermediate layer can be changed without changing the condition of the fast atom beam from the atomic beam source 6. Thus, the intermediate layer 20 can be formed in which the physical characteristics such as optical characteristic and electric and electromagnetic characteristics (insulation property) to be required for the device are controlled, independently from the etching condition of the substrate 4 with the fast atom beam.

In the present example, it is possible to restrain that metal elements of the target holding substrate 8 are mixed into the bonding substrate (containing the intermediate layer) as an impurity. That is, it is possible to restrain that the manufacturing line is polluted with the scattering of metal elements which exist in the device and another device is polluted with a metal impurity adhered in the manufacturing process. Thus, even if the bonded substrates are applied to the manufacturing line at the following stage, the metal impurity never adhere to the manufacturing line and the other device and it is possible to prevent the obstruction of the function of the other device.

According to the present example, in case that the substrates are bonded at the room-temperature, it is possible to restrain that the impurity adheres to the substrate. When the intermediate layer is disposed between the substrates, it is possible to independently control the forming of the intermediate layer and the etching of the bonding surface. Also, it is possible to improve the reliability and manufacturing yield of the device using the substrates bonded by the room-temperature bonding. Furthermore, it is possible to reduce a possibility of pollution of the manufacturing line of the device using the substrates bonded by the room-temperature bonding with the impurities.

### [Embodiment]

The room-temperature bonding apparatus and the room-temperature bonding method according to an embodiment of the present invention will be described. The embodiment is different from the first example in that a covering member 50 having a predetermined characteristic is disposed inside the vacuum chamber 1. Below, the difference from the first example will be mainly described.

FIG. 5 is a sectional view showing the configuration of the room-temperature bonding apparatus according to the present embodiment. In the present embodiment, the inner surface of the vacuum chamber 1 of the room-temperature bonding apparatus is covered with the covering member 50 using a material which is difficult to be sputtered (etched) with the fast atom beam or which does not obstruct the function of the device obtained by bonding the upper substrate 4 and the lower substrate 4 even if the material is present in the bonding surface of the substrate 4. However, the material which is difficult to be sputtered (etched) with the fast atom beam and the material which does not obstruct the function of the device are the same as described in the first example.

For example, when the vacuum chamber 1 has a rectangular parallelepiped shape, the covering member 50 is formed to cover a total six surfaces of the two surfaces of inner top and bottom surfaces of the vacuum chamber 1 and the four surfaces of inner front and back side surfaces and inner left and right side surfaces. The covering member 50 is disposed in the neighborhood of or in contact with the six surfaces, inside the vacuum chamber 1. Or, for example, when the vacuum chamber 1 has a cylindrical shape (the top and bottom are planes), the covering member 50 is disposed to cover a total three inner surfaces of the two surfaces of the top and bottom surfaces inside the vacuum chamber 1 and a side surface of the circular cylinder inner curved surface. The covering member 50 is disposed in neighborhood of the three surfaces, or in contact with the three surfaces inside the vacuum chamber 1. Note that the covering member 50 is exemplified by a thin plate member and a thin film member, and may be close to each other and may be separated. Also, the covering member 50 is disposed to be detachable and exchangeable from the vacuum chamber 1.

When the covering member 50 which covers the inside of the vacuum chamber 1 is not disposed, a case would be considered that a part of the fast atom beam reaches the inside of the vacuum chamber 1 to sputter and etch the inside of the vacuum chamber 1, so that a material of the vacuum chamber 1 is taken into the intermediate layer and adheres to the substrate 4. However, in the present embodiment, because the covering member 50 covers the inside of the vacuum chamber 1, the part of the fast atom beam does not reach the vacuum chamber 1. Thus, it can be prevented that the inside of the vacuum chamber 1 is sputtered and etched so that the material of the vacuum chamber 1 is taken into the intermediate layer and adheres to the substrate 4.

Also, a covering film of the target material is formed on the surface inside the vacuum chamber 1 of the room-temperature bonding apparatus by repeating the sputtering of the target. A situation may occur that when the covering film becomes thick, the covering film is easy to peel so that the peeled film is taken into the intermediate layer. However, in the present embodiment, by designing the covering member 50 so as to be detachable or exchangeable from the vacuum chamber 1, it is possible to prevent that the covering film becomes thick and becomes easy to peel so that the peeled film gives adverse influence on the intermediate layer, while holding the above effect.

Because the other part of the configuration of the room-temperature bonding apparatus of the present embodiment is same as that of the first example, the description is omitted.

Next, because the room-temperature bonding method (the operating method of the room-temperature bonding apparatus) according to the present embodiment is same as that of the first example about, the description is omitted.

In the present embodiment, the inside of the vacuum chamber 1 where the sputtering of the bonded objects is carried out is covered with a material which is difficult to be sputtered (etched) with the fast atom beam or which does not obstruct the function of the device obtained by bonding the upper substrate 4 and the lower substrate 4 even if the material is present in the bonding surface of the substrate. Thus, it is possible to prevent that the vacuum chamber 1 (formed of stainless, aluminum and so on) functions as a supply source of the intermediate layer. That is, it becomes possible to improve the controllability of the forming of the intermediate layer by the plurality of target materials by preventing the sputtering in the background.

In the present embodiment, it is possible to prevent that the metal elements of the vacuum chamber 1 are mixed into the bonding substrate (containing the intermediate layer) as an impurity. That is, it is possible to restrain a possibility that the manufacturing line is polluted due to the scatter of the metal elements existing in the device in the manufacturing process and another device is polluted with a metal impurity adhered. Thus, when the bonding substrate is applied to the following manufacturing line, there is no case that the metal impurity adheres to the manufacturing line and the other device and obstructs the function of the other device.

Note that the room-temperature bonding apparatus of the present embodiment may not have the targets 7 (or 11 to 15), the target holding substrates 8a and 8b, and the target moving mechanisms 40a and 40b. In such a case, the upper substrate 4 and the lower substrate 4 are subjected to the the room-temperature bonding without using the intermediate layers after the bonding surfaces of the substrates are sputtered and cleaned with the fast atom beam. In this case, it could be considered that when the covering member 50 which covers the inside of the vacuum chamber 1 is not disposed, a part of the fast atom beam reaches the inner surface of the vacuum chamber 1 to sputter and etch the inner surface of the vacuum chamber 1 so that the materials of the vacuum chamber 1 adhere to the bonding surfaces of the substrates 4. However, because the inside of the vacuum chamber 1 is covered with the covering member 50 as mentioned above, there is no case that a part of the fast atom beam reaches the inner surface of the vacuum chamber 1. Thus, even when the targets 7 (or 11 to 15), the target holding substrates 8a and 8b, and the target moving mechanisms 40a and 40b are not disposed, it can be prevented that the inner surface of the vacuum chamber 1 is sputtered and etched so that the material of the vacuum chamber 1 adheres to the substrate 4.

According to the present embodiment, it becomes possible to restrain that the impurity adheres to the substrate, when the substrates are subjected to the room-temperature bonding. It becomes possible to improve the manufacturing yield of the devices using the substrates bonded by the room-temperature bonding and the reliability of the devices. It becomes possible to reduce a possibility of pollution of the manufacturing line of the device using the substrates bonded by the room-temperature bonding with the impurity.

### [Second Example]

The room-temperature bonding apparatus and the room-temperature bonding method according to a second example serving to explain features of the present invention will be described. The second example is different from the first example in that each of the components of the vacuum chamber 1 is formed of a material having a predetermined characteristic or a surface portion where an activation beam is irradiated is covered with the covering member formed of the material. Below, the difference from the first example will be mainly described.

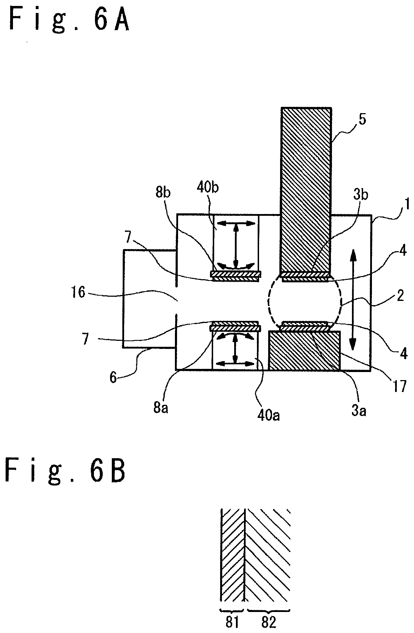

FIG. 6A is a sectional view showing the configuration of the room-temperature bonding apparatus according to the present example. In the present example, the positioning stage carriage 3a, the alignment mechanism 17, the pressure bonding mechanism 5, the electrostatic chuck 3b, the target moving mechanisms 40a and 40b, which are the components of the vacuum chamber 1 of the room-temperature bonding apparatus, are formed of a material which is difficult to be sputtered (etched) with the fast atom beam or which does not obstruct the function of the device obtained by bonding of the upper substrate 4 and the lower substrate 4 even if the material is present in the bonding surface. Here, the material which is difficult to be sputtered (etched) with the fast atom beam or the material which does not obstruct a function of the device are the same as described in the first example.

Or, the outer surfaces of the positioning stage carriage 3a, the alignment mechanism 17, the pressure bonding mechanism 5, the electrostatic chuck 3b, the target moving mechanisms 40a and 40b, which are components of the vacuum chamber 1 of the room-temperature bonding apparatus, are covered with the covering film using the material which is difficult to be sputtered (etched) with the fast atom beam or which does not obstruct the function of the device obtained by bonding the upper substrate 4 and the lower substrate 4 even if the material is in the bonding surface. However, the material which is difficult to be sputtered (etched) with the fast atom beam or the material which does not obstruct the function of the device are the same as described in the first example.

FIG. 6B is a sectional view schematically showing an example of a covering layer. The members 82 of the positioning stage carriage 3a, the alignment mechanism 17, the pressure bonding mechanism 5, the electrostatic chuck 3b, and the target moving mechanisms 40a and 40b, which are formed of, for example, stainless and/or aluminum, are covered by a covering layer 81 (of the material which is difficult to be sputtered with the fast atom beam or which does not obstruct the function of the device). The covering layer 81 can be regarded as the covering member 50 in the embodiment. The covering layer 81 is exemplified as a layer formed by directly coating the above material (a film) on the member 82 of a main body or a diffusion layer obtained when the material is diffused into the member 82 of the main body.

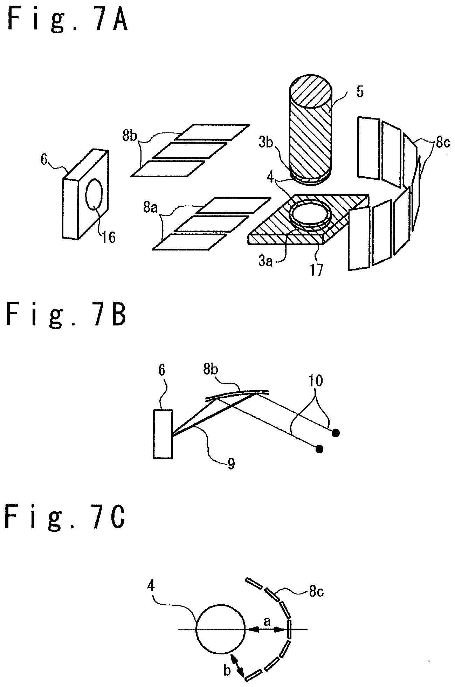

FIG. 7A is a perspective view schematically showing the configuration of the room-temperature bonding apparatus according to the present example. As shown in FIG. 7A, in the room-temperature bonding apparatus, a plurality of target holding substrates 8c (containing the targets 7) may be installed like an arc in a front position of the atomic beam source 6. The target holding substrates 8c are arranged to surround the (circular) substrate 4 in a circumferential direction. Each of the plurality of target holding substrates 8c may have a curved shape. Moreover, a plurality of target holding substrates 8a and a plurality of target holding substrates 8b may be installed, respectively. In this way, because an area of the targets 7 to be sputtered becomes wider by installing the plurality of target holding substrates 8a, the plurality of target holding substrates 8b, and the plurality of target holding substrates 8c, the sputtered particles from the targets 7 are irradiated to the bonding surfaces of the upper substrate 4 and lower substrate 4 to sufficiently cover the area of the bonding surfaces. Accordingly, the intermediate layer can be more uniformly formed on the bonding surface of the substrate 4. Also, by surrounding the periphery of the substrate 4 physically by the targets 7, it is possible to restrain that unnecessary material is mixed into the intermediate layer from the inner surface of the vacuum chamber 1, other parts, and other components.

FIG. 7B is a sectional view schematically showing an example of the target holding substrates 8a and 8b. As shown in FIG. 7B, it is desirable that the irradiated surfaces of the target holding substrates 8a and 8b have curved surfaces so that lines of the reflected beam when the fast atom beam 9 from the atomic beam source 6 is irradiated to the irradiated surfaces are parallel to each other toward the bonding surfaces of the substrates 4. Thus, it is possible to ease a thickness distribution of the intermediate layer in the direction of the surface of the substrate 4. Also, FIG. 7C is a sectional view schematically showing an example of the target holding substrates 8c. As shown in FIG. 7C, the irradiated surfaces of the target holding substrates 8c are arranged in a direction orthogonal to the bonding surface of the substrate 4 to surround the semicircle of the substrate 4. By arranging the targets so as to put the bonding surface of the substrate 4 in the semicircumference, the sputtering particles are incident on the area of the bonding surface of the substrate 4 which is farther from the targets 7 on the target holding substrates 8a and 8b. The intermediate layer can be formed uniformly on the bonding surface.

In case that each component of the vacuum chamber 1 is not formed of a predetermined material and that the covering layer 81 is not disposed on the surface of each component, it could be considered that a part of the fast atom beam reaches each component so that each component is sputtered and etched and a material of each component is taken into the intermediate layer. However, in the present example, each component is formed of a predetermined material and the covering layer 81 is disposed on each component. For this reason, even if the part of the fast atom beam reaches the surface of each component, the surface of the component is not etched and an adverse influence to the device can be avoided in the etching.

The other part of the configuration of the room-temperature bonding apparatus of the present example is the same as that of the first example. Accordingly, the description is omitted.

Next, the room-temperature bonding method (the operation of the room-temperature bonding apparatus) according to the present example is the same as in the first example. Accordingly, the explanation is omitted.

When the substrate 4 is physically sputtered, supporting members of the substrate 4 (the positioning stage carriage 3a, the alignment mechanism 17, the pressure bonding mechanism 5, the electrostatic chuck 3b) are arranged in the position which is nearest to the substrate 4 in the bonding environment. Therefore, in the present example, the phenomenon can be prevented that the supporting members function as a sputtering target so that the supporting members are taken into the intermediate layer formed on the bonding surface. Thus, the controllability of the forming of the intermediate layer while using a plurality of targets can be improved.

Note that in the present example, if at least one of the positioning stage carriage 3a, the alignment mechanism 17, the pressure bonding mechanism 5, the electrostatic chuck 3b and the target moving mechanisms 40a and 40b has a configuration mentioned above, the above-mentioned effect can be obtained although the degree of the effect is different. That is, if at least one member is formed of a material which is is difficult to be sputtered with the fast atom beam or which does not obstruct the function of the device obtained by bonding the upper substrate and the lower substrate even if the material is in the bonding surface of the substrates, or the irradiated surface of the fast atom beam is covered with the covering layer using the material, there is an impurity reduction effect in the intermediate layer and so on. Thus, even if a part of the fast atom beam reaches the surface of each component, the surface is not sputtered and etched, and it is possible to avoid adverse influence on the device, even in case of being etched.

In the present example, it is possible to prevent the metal element of each component of the vacuum chamber 1 from being mixed into the bonding substrate (containing the intermediate layer) as an impurity. That is, a possibility can be restrained that the manufacturing line and the other device are polluted with the metal impurity adhered to them through the scatter of the metal existing in the device in the manufacturing process. Thus, even if the bonding substrate is applied to the manufacturing line at the following stage, the metal impurity never adheres to the manufacturing line and the other device, and it is possible to reduce the obstruction of the function of the other device.

Note that the room-temperature bonding apparatus in the present example may not have the targets 7 (or 11 to 15), the target holding substrates 8a and 8b, and the target moving mechanisms 40a and 40b. In such a case, when the upper substrate 4 and the lower substrate 4 are bonded at the room-temperature without using the intermediate layer, the bonding surfaces of the substrates are cleaned by sputtering the bonding surfaces with the fast atom beam. At this time, when each component of the vacuum chamber 1 is not formed of the predetermined material and when the covering layer 81 is not disposed on the surface of each component, it could be considered that a part of the fast atom beam reaches each component, so that each component is sputtered and etched and the material of each component is taken into the bonding surface of the substrate 4. However, in the present example, each component is formed of the predetermined material and the covering layer 81 is disposed on the surface of each component. Therefore, even if the target 7 (or 11 to 15), the target holding substrates 8a and 8b, and the target moving mechanisms 40a and 40b are not disposed, and even if a part of the fast atom beam reaches the surface of each component, the surface is not etched or the adverse influence on the device can be avoided even in the sputtering or etching.

According to the present example, when the substrates are bonded at the room-temperature, it is possible to restrain that the impurity adheres to the substrate. Also, it is possible to improve a manufacturing yield of the devices using the substrates bonded by the room-temperature bonding and the reliability of the devices. The possibility can be reduced that the manufacturing line of the device using the substrates bonded by the room-temperature bonding is polluted with the impurity.

### [Third Example]

The room-temperature bonding apparatus and the room-temperature bonding method according to a third example serving to explain features of the present invention will be described. The third example is different from the first example in that the atomic beam source 6 of the vacuum chamber 1 is formed of a material having predetermined characteristics, or a portion of the atomic beam source 6 irradiated with the activation beam is covered with the covering member using the material. Below, the difference point from the first example will mainly be described.

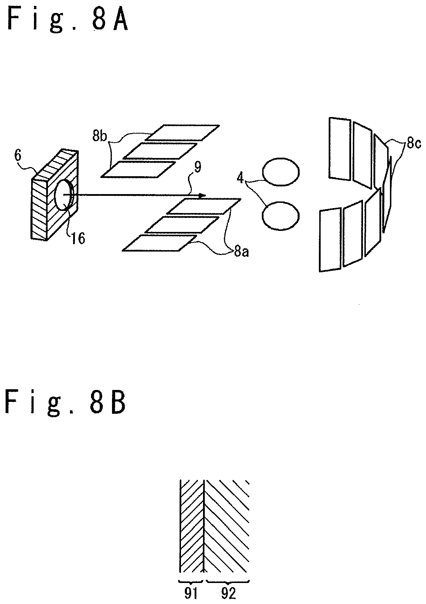

FIG. 8A is a sectional view showing the configuration of the room-temperature bonding apparatus according to the present example. In the present example, the atomic beam source 6 in the vacuum chamber 1 of the room-temperature bonding apparatus is formed of a material which is difficult to be sputtered (etched) with the fast atom beam or which does not obstruct the function of the device obtained by bonding the upper substrate 4 and the lower substrate 4 even if the material is in the bonding surface of the substrates 4. Here, the material which is difficult to be sputtered (etched) with the fast atom beam or which does not obstruct the function of the device is the same as in the first example.

Or, the portion of the atomic beam source 6 irradiated with the fast atom beam is covered with a covering layer formed of a material which is difficult to be sputtered (etched) with the fast atom beam or which does not obstruct the function of the device obtained by bonding the upper substrate 4 and the lower substrate 4 even if the material is in the bonding surface of the substrate. However, the material which is difficult to be sputtered (etched) with the fast atom beam or which does not obstruct the function of the device is the same as in the first example.

FIG. 8B is a sectional view schematically showing an example of the covering layer. The atomic beam source 6 has a configuration that a member 92 (e.g. stainless, aluminum) of a main body of the atomic beam source 6 is covered with a covering layer 91 (of the material which is difficult to be sputtered with the fast atom beam or which does not obstruct the function of the device). The covering layer 91 can be regarded as the covering member 50 in the embodiment. The covering layer 91 is exemplified by a layer formed by directly coating (film forming) the member 92 of the main body with the above material and a diffusion layer when the above material is diffused in the member 92 of the main body.

When the atomic beam source 6 of the vacuum chamber 1 is not formed of the predetermined material or when the covering layer 91 is not formed on the surface of the atomic beam source 6, it could be considered that a part of the fast atom beam reaches a part of the housing, so that the part of the housing is sputtered and etched and the material of the housing is taken into the intermediate layer. However, in the present example, the housing is formed of the predetermined material and the covering layer 91 is disposed on the surface of the housing. Therefore, the adverse influence on the device can be avoided even if the surface is not sputtered and etched even if the part of the fast atom beam reaches the surface of the housing.

Because the other part of the configuration of the room-temperature bonding apparatus of the present example is the same as that of the first example, the description is omitted.

Next, because the room-temperature bonding method (the operation of the room-temperature bonding apparatus) according to the present example is the same as that of the first example, the description is omitted.

The main body of the atomic beam source 6 is generally covered with the housing of the metal material such as stainless steel and aluminum. In this case, there would be a case that the atomic beam source 6 sputters a part of its own housing upon irradiating and a case that two or more atomic beam sources 6 sputter the mutual housings of metal material. That is, a situation can be considered that the material of the housing is taken into the bonding surface of the substrate 4. However, in the present example, it is possible to prevent that an un-intentional intermediate layer is formed on the bonding surfaces, by using the housing of the atomic beam source 6 of the above configuration. Thus, the controllability of the forming of the intermediate layer by the plurality of targets can be improved.

In the present example, it is possible to prevent the metal element of the atomic beam source 6 in the vacuum chamber 1 from being mixed into the bonding substrate (containing the intermediate layer) as an impurity. That is, in the manufacturing process, a possibility can be restrained that the metal impurity adheres to the manufacturing line and the other device through the scatter of the metal existing in the device and so on to pollute them. Thus, even if the bonding substrate is applied to the manufacturing line at the following stage, it is possible to prevent that the metal impurity adheres to the manufacturing line and the other device and that the function of the other device is obstructed.

Note that the room-temperature bonding apparatus of the present example may not have the targets 7 (or 11 to 15), the target holding substrates 8a and 8b, and the target moving mechanisms 40a and 40b. In this case, when the upper substrate 4 and the lower substrate 4 are bonded at the room-temperature without using the intermediate layer, the bonding surfaces of the substrates are sputtered with the fast atom beam so as to clean them and then are bonded at room-temperature. AT this time, defects that the atomic beam source 6 itself sputters a part of its own housing in case of irradiating and two or more atomic beam sources 6 sputter mutual housing of metal material as target may happen. In this case, a situation could be considered that the material of the housing is taken into the bonding surfaces of the substrates 4. However, in the present example, it is possible to prevent that an un-intentional intermediate layer component is formed on the bonding surfaces by using he housing of the atomic beam source 6 of the above configuration.

In the present example, when the substrates are bonded at the room-temperature, it is possible to restrain that the impurity adheres to the substrate. It is possible to improve the manufacturing yield of the devices using the substrates bonded by the room-temperature bonding and the reliability of the devices. The possibility can be reduced that the manufacturing line of the device using the substrates bonded by the room-temperature bonding is polluted with an impurity.

### <Examples>

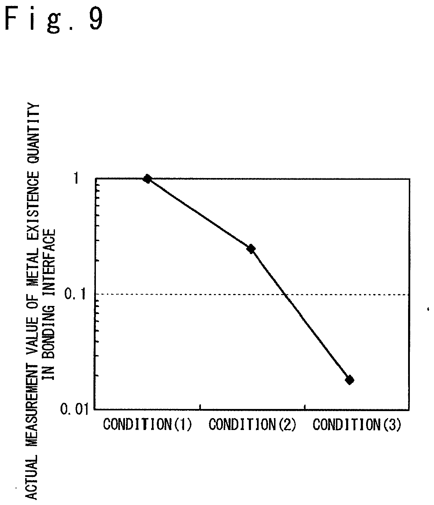

Examples of the room-temperature bonding apparatus to which the techniques of the above embodiment and examples are applied will be described. FIG. 9 is a graph showing the effect of the examples to which the techniques of the above embodiment and examples are applied. The horizontal axis shows a condition of the room-temperature bonding apparatus and the vertical axis shows a measurement value of an existence quantity of the metal impurity in the bonding surface (intermediate layer) when two sheets of substrates are bonded through the intermediate layer(s). Here, the condition (1) shows a case where the techniques of the above embodiment and examples are not used, the condition (2) shows a case where the technique of the above embodiment is used, and the condition (3) shows a case where the techniques of the above first to third examples and of the embodiment are used. Also, the measurement value of the existence quantity of the metal impurity in the bonding surface (intermediate layer) is a metal pollution quantity measurement value (average) by TRXF (Total Reflection X-ray Fluorescence), and the measurement value of the condition (1) is "1", and the measurement values of the other conditions (2) and (3) are normalized.

By applying the technique of each of the above embodiment and examples to the room-temperature bonding apparatus (conditions (2) and (3)), an existence quantity of the metal impurity in the bonding surface (intermediate layer) can be greatly reduced, compared with a case where any technique of the above embodiment and examples is not applied to the room-temperature bonding apparatus (condition (1)). That is, in the above embodiment and examples, in case of sputtering a plurality of targets when the substrates are bonded at the room-temperature, a material which is difficult to be etched compared with the targets, or which does not obstruct the function of the device obtained by bonding the substrates even if the material is in the bonding surfaces is used for members around the substrates to be sputtered. As a result, it was confirmed that the existence quantity of metal impurity in the intermediate layer in the bonding interface could be greatly reduced. As an example, an existence density of the impurity which exists in the bonding surface is less than 1×10¹⁴ atoms/cm². Thus, the physical characteristics such as optical characteristic and electric and electromagnetic characteristics (insulation) which are required for the device can be controlled.

Also, a sputter quantity of the intermediate layer (a bonding surface adhesion quantity) conventionally depended on the etching condition of the bonding substrate in Patent Literature 3. However, in the present invention, the sputter quantity of the intermediate layer (bonding surface adhesion quantity) can be controlled independently from the etching condition. Thus, it was confirmed that an optional intermediate layer existence quantity could be realized to fit with an application of the device.

The technique of the embodiment and each example can be applied to the other embodiment and examples unless a technical contradiction occurs. The room-temperature bonding apparatus and the room-temperature bonding method according to the present invention are defined in the appended claims. The scope of the present invention is limited by the claims.

## Claims

1. A room-temperature bonding apparatus comprising:
a vacuum chamber (1);
a first holding mechanism (3a) disposed in said vacuum chamber (1) to hold a first substrate (4);
a second holding mechanism (3b) disposed in said vacuum chamber (1) to hold a second substrate (4);
a target holding mechanism (8) disposed in said vacuum chamber (1) to hold at least one target (7;11-15);
a beam source (6) disposed in said vacuum chamber (1) to irradiate an activation beam to a bonding surface of the first substrate (4) and a bonding surface of the second substrate (4) and to the exposed area of said target holding mechanism (8), wherein said beam source (6) is one that generates a fast atom beam;
a pressure bonding mechanism (5) disposed in said vacuum chamber (1) to bond the first and second substrates (4) such that the bonding surface of the first and second substrates (4) irradiated with the activation beam are opposed to each other, and
a covering member (50) covering the inner surface of said vacuum chamber (1),
wherein said covering member (50) is disposed to be detachable or exchangeable from said vacuum chamber (1) and is formed of a first material,
wherein said target holding mechanism (8) has a plurality of areas in which a plurality of said targets (7,12-14) or pseudo targets (11, 15) of the first material can be arranged,
wherein a pseudo target of the first material is arranged in at least one of the plurality of areas,
wherein, when the first substrate (4) is a silicon substrate, the first material comprises silicon or silicon oxide as main component, or, when the first substrate (4) is a sapphire substrate, the first material comprises aluminum or aluminum oxide as main component, or, when the targets (7, 12-14) are formed of metal materials, the first material is an insulator like silicon oxide or aluminum oxide, or ceramic material, or yttrium, or tungsten.

2. The room-temperature bonding apparatus according to claim 1, wherein the covering member (50) comprises a thin plate member or a thin film member covering the inner surface of said vacuum chamber (1) irradiated with the activation beam,.

3. The room-temperature bonding apparatus according to claim 1 or 2, wherein said target holding mechanism (8) is formed of the first material, or a surface of said target holding mechanism (8) irradiated with the activation beam is covered with another covering member of the first material.

4. A room-temperature bonding method comprising:
providing a room-temperature bonding apparatus according to claim 1, 2 or 3;
holding a first substrate (4) by said first holding mechanism (3a) and a second substrate (4) by said second holding mechanism (3b);
irradiating the activation beam from said beam source (6) to bonding surfaces of the first and second substrates (4) and to the exposed area of said target holding mechanism (8); and
bonding the first and second substrates (4) by said pressure bonding mechanism (5) such that the bonding surfaces of the first and second substrates (4) irradiated with the activation beam are opposed to each other.

## Patentansprüche

1. Eine Raumtemperatur-Bondingvorrichtung mit:
einer Unterdruckkammer (1),
einem ersten Haltemechanismus (3a), der in der Unterdruckkammer (1) zum Halten eines ersten Substrats (4) angeordnet ist,
einem zweiten Haltemechanismus (3b), der in der Unterdruckkammer (1) zum Halten eines zweiten Substrats (4) angeordnet ist,
einem Target-Haltemechanismus (8), der in der Unterdruckkammer (1) zum Halten von zumindest einem Target (7;11-15) angeordnet ist,
einer Strahlenquelle (6), die in der Unterdruckkammer (1) zum Aufstrahlen eines Aktivierungsstrahls auf eine Bonding-Oberfläche des ersten Substrats (4) und eine Bonding-Oberfläche des zweiten Substrats (4) und auf den freiliegenden Bereich des Target-Haltemechanismus (8) angeordnet ist,
wobei die Strahlenquelle (6) eine solche ist, die einen schnellen Atomstrahl erzeugt,
einem Druck-Bondingmechanismus (5), der in der Unterdruckkammer (1) zum Bonden der ersten und zweiten Substrats (4) so angeordnet ist, dass die Bonding-Oberfläche der ersten und zweiten Substrate (4), die mit dem Aktivierungsstrahl bestrahlt werden, einander gegenüberliegen, und
einem Abdeckelement (50), dass die innere Oberfläche der Unterdruckkammer (1) abdeckt,
wobei das Abdeckelement (50) angeordnet ist, um von der Unterdruckkammer (1) abnehmbar oder austauschbar zu sein, und es aus einem ersten Material gebildet ist,
wobei der Target-Haltemechanismus (8) eine Vielzahl von Bereichen besitzt, in der eine Vielzahl der Targets (7,12-14) oder Pseudotargets (11,15) des ersten Materials angeordnet werden können,
wobei ein Pseudotarget des ersten Materials in zumindest einem der Vielzahl von Bereichen angeordnet ist,
wobei, wenn das erste Substrat (4) ein Siliziumsubstrat ist, das erste Material Silizium oder Siliziumoxid als Hauptkomponente aufweist,
oder, wenn das erste Substrat (4) ein Saphirsubstrat ist, das erste Material Aluminium oder Aluminiumoxid als Hauptkomponente aufweist,
oder, wenn die Targets (7,12-14) aus Metallmaterialen gebildet sind, das erste Material ein Isolator wie Siliziumoxid oder Aluminiumoxid oder Keramikmaterial oder Yttrium oder Wolfram ist.

2. Die Raumtemperatur-Bondingvorrichtung gemäß Anspruch 1, wobei das Abdeckelement (50) ein dünnes Plattenelement oder ein dünnes Schichtelement aufweist, das die innere Oberfläche der Unterdruckkammer (4), die mit dem Aktivierungsstrahl bestrahlt wird, abdeckt.

3. Die Raumtemperatur-Bondingvorrichtung gemäß Anspruch 1 oder 2, wobei der Target-Haltemechanismus (8) aus dem ersten Material gebildet ist, oder eine Oberfläche des Target-Haltemechanismus (8), die mit dem Aktivierungsstrahl bestrahlt wird, mit einem anderen Abdeckelement aus dem ersten Material abgedeckt ist.

4. Ein Raumtemperatur-Bondingverfahren mit:
Vorsehen einer Raumtemperatur-Bondingvorrichtung gemäß Anspruch 1, 2 oder 3,
Halten eines ersten Substrats (4) durch den ersten Haltemechanismus (3a) und eines zweiten Substrats (4) durch den zweiten Haltemechanismus (3b),
Aufstrahlen des Aktivierungsstrahls von der Strahlenquelle (6) zu Bonding-Oberflächen der ersten und zweiten Substrate (4) und zu dem freiliegenden Bereich des Target-Haltemechanismus (8), und
Bonden der ersten und zweiten Substrate (4) durch den Druck-Bondingmechanismus (5) so, dass die Bonding-Oberflächen der ersten und zweiten Substrate (4), die mit dem Aktivierungsstrahl bestrahlt werden, einander gegenüberliegen.

## Revendications

1. Installation de collage à la température ambiante, comprenant :
une chambre (1) sous vide ;
un premier mécanisme (3) de maintien, disposé dans la chambre (1) sous vide pour maintenir un premier substrat (4) ;
un deuxième mécanisme (3b) de maintien, disposé dans la chambre (1) sous vide pour maintenir un deuxième substrat (4) ;
un mécanisme (8) de maintien d'une cible, disposé dans la chambre (1) sous vide pour maintenir au moins une cible (7 ; 11 à 15) ;
une source (6) de faisceau, disposée dans la chambre (1) sous vide pour soumettre à un faisceau d'activation une surface de collage du premier substrat (4) et une surface de collage du deuxième substrat (4) et une région à découvert du mécanisme (8) de maintien d'une cible,
la source (6) de faisceau étant une source, qui produit un faisceau d'atomes rapides ;
un mécanisme (5) de collage par la pression, disposé dans la chambre (1) sous vide pour coller le premier et le deuxième substrat (4), de manière à ce que la surface de collage du premier et du deuxième substrats (4), soumises au faisceau d'activation, soient opposées l'une à l'autre, et
un élément (50) de recouvrement recouvrant la surface intérieure de la chambre (1) sous vide,
dans laquelle l'élément (50) de recouvrement est disposé de manière à pouvoir être détaché de la chambre (1) sous vide ou à pouvoir être échangé et est en un premier matériau,
dans laquelle le mécanisme (8) de maintien d'une cible a une pluralité de régions dans lesquelles une pluralité des cibles (7 ; 12 à 14) ou de pseudos cibles (11, 15) en le premier matériau peuvent être disposées,
dans laquelle une pseudo cible en le premier matériau est disposée dans au moins l'une de la pluralité de régions,
dans laquelle, lorsque le premier substrat (4) est un substrat en silicium, le premier matériau comprend du silicium ou de l'oxide de silicium comme constituant principal,
ou lorsque le premier substrat (4) est un substrat en saphir, le premier matériau comprend de l'aluminium ou de l'oxyde d'aluminium comme constituant principal,
ou lorsque les cibles (7, 12 à 14) sont en des matériaux métalliques, le premier matériau est un isolant, comme de l'oxyde de silicium ou de l'oxyde d'aluminium, ou un matériau céramique, ou de l'yttrium, ou du tungstène.

2. Installation de collage à la température ambiante suivant la revendication 1, dans laquelle l'élément (50) de recouvrement comprend un mince élément en plaque ou un mince élément pelliculaire recouvrant la surface intérieure de la chambre (1) sous vide soumise au faisceau d'activation.

3. Installation de collage à la température ambiante suivant la revendication 1 ou 2, dans laquelle le mécanisme (8) de maintien d'une cible est en le premier matériau, ou une surface du mécanisme (8) de maintien d'une cible soumis au faisceau d'activation est recouverte d'un autre élément de recouvrement en le premier matériau.

4. Procédé de collage à la température ambiante, dans lequel :
on se procure une installation de collage à la température ambiante suivant la revendication 1, 2 ou 3 ;
on maintient un premier substrat (4) par le premier mécanisme (3a) de maintien et un deuxième substrat (4) par le deuxième mécanisme (3b) de maintien ;
on soumet au faisceau d'activation de la source (6) de faisceau des surfaces de collage du premier et du deuxième substrats (4) et la région à découvert du mécanisme (8) de maintien d'une cible ; et
on colle le premier et le deuxième substrats (4) par le mécanisme (5) de collage par la pression, de manière à ce que les surfaces de collage du premier et du deuxième substrats (4), soumises au faisceau d'activation, soient opposées l'une à l'autre.
